# EUROPÄISCHE PATENTSCHRIFT

(11) **EP 0 590 354 B1**
(45) Veröffentlichungstag und Bekanntmachung des Hinweises auf die Patenterteilung: **27.03.1996**
(21) Anmeldenummer: 93114217.8
(22) Anmeldetag: 04.09.1993
(51) Int. Cl.: H05K 7/20

(54) **Anordnung mit einer Leiterplatte, mindestens einem Leistungsbauelement und einem Kühlkörper**
Device with a board, a heat sink and at least one power component
Dispositif composé d'un circuit imprimé d'un radiateur et d'au moins un composant de puissance

(30) Priorität: 29.09.1992 DE 4232575
(43) Veröffentlichungstag der Anmeldung: 06.04.1994
(73) Patentinhaber: ROBERT BOSCH GMBH, D-70442 Stuttgart (DE)
(72) Erfinder: Wiesa, Thomas, Dipl.-Ing., D-71665 Vaihingen/Enz (DE)

(56) Entgegenhaltungen:
- FR-A- 2 207 401
- US-A- 4 941 067
- US-A- 5 172 301
- RESEARCH DISCLOSURE Nr. 319 , November 1990 , HAVANT GB Seite 886 XP000160179 'Applying thermal transfer compound under quadpads'
- IBM TECHNICAL DISCLOSURE BULLETIN. Bd. 33, Nr. 4 , September 1990 , NEW YORK US Seiten 403 - 404 XP000106478 'Thermal enhancement for a printed wiring board, thermal finger pad'
- PATENT ABSTRACTS OF JAPAN vol. 014, no. 225 (E-0927)14. Mai 1990 & JP-A-02 058 358 (IBIDEN CO LTD) 27. Februar 1990
- PATENT ABSTRACTS OF JAPAN vol. 009, no. 251 (E-348)8. Oktober 1985 & JP-A-60 100 457 (MATSUSHITA DENKI SANGYO KK) 4. Juni 1985

## Beschreibung

### Stand der Technik

Die Erfindung betrifft eine Anordnung nach der Gattung des Hauptanspruchs.

Bei bekannten Anordnungen dieser Art bereitet es häufig Schwierigkeiten, die in dem Leistungsbauelement erzeugte Verlustleistung an den Kühlkörper abzuführen, da die Leiterplatte an mindestens einer ihrer beiden Hauptoberflächen mit einer Vielzahl von verschiedene Potentiale führenden Leiterbahnen belegt ist, die untereinander und mit dem Kühlkörper nicht kurzgeschlossen werden dürfen.

Aus Patent Abstracts of Japan zur JP 2058358 (Band 14, Nr. 225 (E-0927), 14.5.1990) ist bereits eine Leiterplatte bekannt, bei der auf der Oberseite und Unterseite eine flächige Leiterbahn vorhanden ist, die durch eine Vielzahl von Löchern, die mit Metall gefüllt sind, miteinander gut wärmeleitend verbunden sind.

Aus der US 4,941,067 ist bereits eine Leiterplatte bekannt, bei der eine gute Wärmeleitung zwischen der Oberseite und Unterseite durch elektrische Durchkontaktierungen hergestellt wird.

### Vorteile der Erfindung

Die erfindungsgemäße Anordnung mit den kennzeichnenden Merkmalen des Hauptanspruchs hat demgegenüber den Vorteil, daß die in dem mindestens einen Leistungsbauelement erzeugte Verlustleistung potentialfrei an den Kühlkörper abgeführt werden kann.

### Zeichnung

Anhand der Zeichnung wird die Erfindung näher erläutert. Es zeigen :
- Figur 1: ein erstes Ausführungsbeispiel einer erfindungsgemäßen Anordnung im Schnitt,
- Figur 2: ein zweites Ausführungsbeispiel einer erfindungsgemäßen Anordnung, ähnlich dem nach Figur 1, im Schnitt,
- Figur 3: einen vergrößerten Schnitt durch eine erfindungsgemäße Anordnung im Bereich der Durchkontaktierungen,
- Figur 4: die Schnittdarstellung nach Figur 3 mit schematisch eingezeichnetem Wärmefluß,
- Figur 5: eine perspektivische Darstellung eines dritten Ausführungsbeispiels der Erfindung,
- Figur 6: eine perspektivische Darstellung eines vierten Ausführungsbeispiels der Erfindung.

### Beschreibung der Ausführungsbeispiele

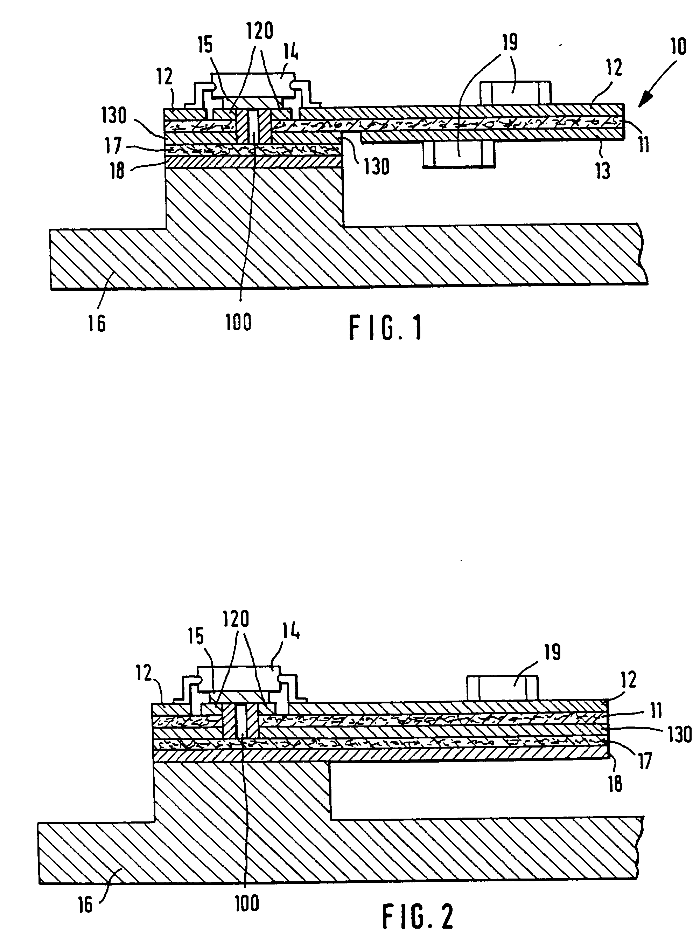

In Figur 1 ist ein erstes Ausführungsbeispiel einer erfindungsgemäßen Anordnung im Schnitt dargestellt. Eine Leiterplatte 10 hat einen aus Glasgewebe bestehenden Kern 11, auf den sowohl an seiner Oberseite als auch an seiner Unterseite ein Netzwerk von Leiterbahnen 12 bzw. 13 aufgebracht ist. An der Oberseite der Leiterplatte 10 befindet sich ein SMD-Leistungsbauelement 14, das über ein aus Blei-Zinn-Weichlot bestehendes Wärmeableitstück 15 mit einer an der Oberseite der Leiterplatte 10 befindlichen großflächigen Leiterbahn 120 gut wärmeleitend und elektrisch leitend verbunden ist. Die Leiterbahn 120 ist Bestandteil des Leiterbahnennetzwerks 12, aber von den übrigen Leiterbahnen dieses Netzwerkes elektrisch getrennt. Im Bereich des SMD-Leistungsbauelements 14 ist die Leiterplatte 10 auf einen Kühlkörper 16 aufgesetzt. Um den Kühlkörper 16 mit der Leiterplatte 10 und mit dem SMD-Leistungsbauelement 14 gut wärmeleitend zu verbinden, ist an der Unterseite der Leiterplatte 10 ebenfalls eine großflächige Leiterbahn 130 angebracht, die über eine Vielzahl von Durchkontaktierungen mit der Leiterbahn 120 elektrisch und wärmeleitend verbunden ist. In Figur 1 ist beispielhaft nur eine dieser Durchkontaktierungen bei 100 angedeutet. Zwischen der Leiterplatte 10 und dem Kühlkörper 16 ist leiterplattenseitig eine Glasgewebeschicht 17 und kühlkörperseitig eine Kupferschicht 18 vorgesehen. Die Kupferschicht 18 ermöglicht dabei eine gute Wärmeverteilung und bildet gleichzeitig eine ebene Auflagefläche zum Kühlkörper 16, während die Glasgewebeschicht 17 für eine potentialmäßige Trennung des SMD-Leistungsbauelements 14 vom Kühlkörper 16 sorgt. Die Leiterplatte 10 trägt an ihrer Oberseite und Unterseite weitere Bauelemente 19, die ebenfalls als SMD-Bauteile ausgebildet sind, aber keine besonders hohe Verlustwärme erzeugen.

Das Ausführungsbeispiel nach Figur 2 unterscheidet sich von dem nach Figur 1 dadurch, daß die Leiterplatte 10 hier nur an ihrer Oberseite weitere, als SMD-Bauteile ausgebildete Bauelemente 19 trägt. Weiterhin erstrecken sich bei diesem Ausführungsbeispiel die Schichten 130, 17, 18 ganzflächig über die gesamte Unterseite der Leiterplatte 10, während der Kühlkörper 16 wie beim Ausführungsbeispiel nach Figur 1 mit der Schicht 18 nur im Bereich des SMD-Leistungsbauelements 14 in Verbindung steht.

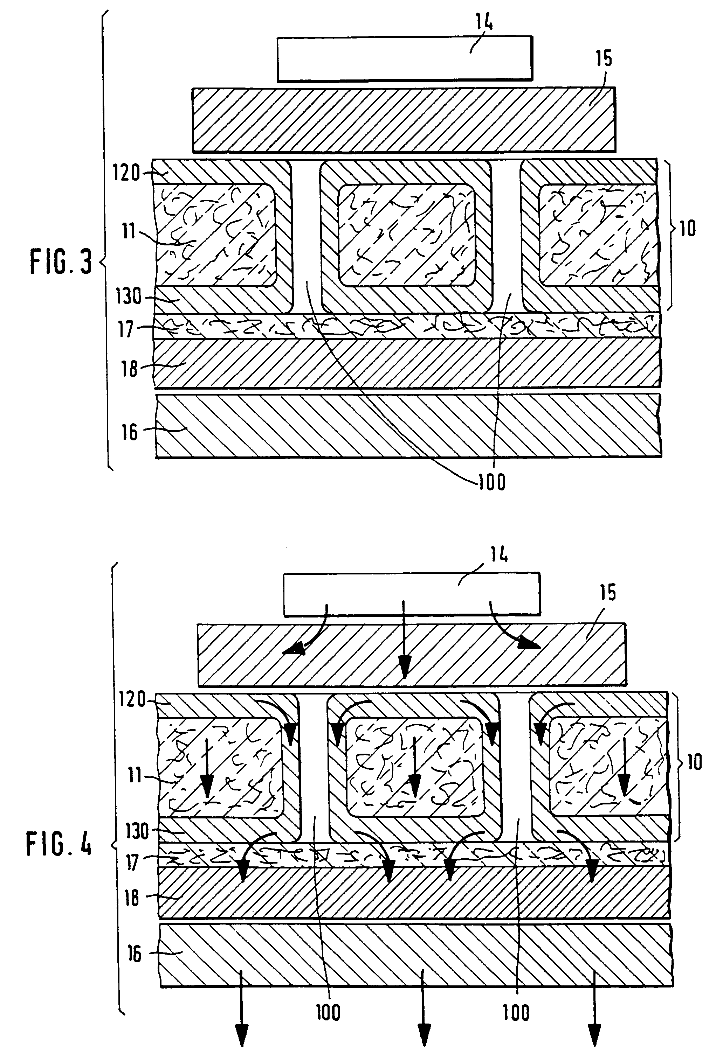

Figur 3 zeigt einen Schnitt durch eine erfindungsgemäße Anordnung mit aufgebrachtem Schichtsystem 17, 18 und Kühlkörper 16 im Bereich der Durchkontaktierungen 100 in stark vergrößerter Darstellung. Die auf die Oberseite und auf die Unterseite des aus Glasgewebe bestehenden Kerns 11 der Leiterplatte 10 aufgebrachten großflächigen Leiterbahnen 120 bzw. 130 bestehen aus Kupfer, haben vorzugsweise jeweils eine Dicke von 35 Mikrometer, sind aber durch aufgebrachtes Weichlot in ihrer Dicke erheblich verstärkt. Weiterhin ist die Leiterplatte 10 im Bereich der großflächigen Leiterbahnen 120, 130 mit einer Vielzahl von Durchkontaktierungen 100 versehen. Diese Durchkontaktierungen bestehen aus Bohrungen in der Leiterplatte 10, die jeweils mit einer Kupferschicht und mit aufgebrachtem Weichlot ausgekleidet sind. Die Glasgewebeschicht 17 ist mit einer Dicke größer als 50 Mikrometer und die Kupferschicht 18 mit einer Dicke größer als 35 Mikrometer ausgeführt.

Figur 4 zeigt die Schnittdarstellung nach Figur 3 mit schematisch eingezeichnetem Wärmefluß. Durch die Pfeile wird angedeutet, wie sich die in dem SMD-Leistungsbauelement 14 erzeugte Verlustwärme zunächst über das Wärmeableitstück 15 verteilt, und von dort aus über die Leiterbahn 120, die Durchkontaktierungen 100 zur Leiterbahn 130 und von dort aus weiter über die Glasgewebeschicht 17 und die Kupferschicht 18 zum Kühlkörper 16 und von dort aus weiter zur umgebenden Atmosphäre gelangt, wo sie beispielsweise durch einen Lüfter abgeführt wird.

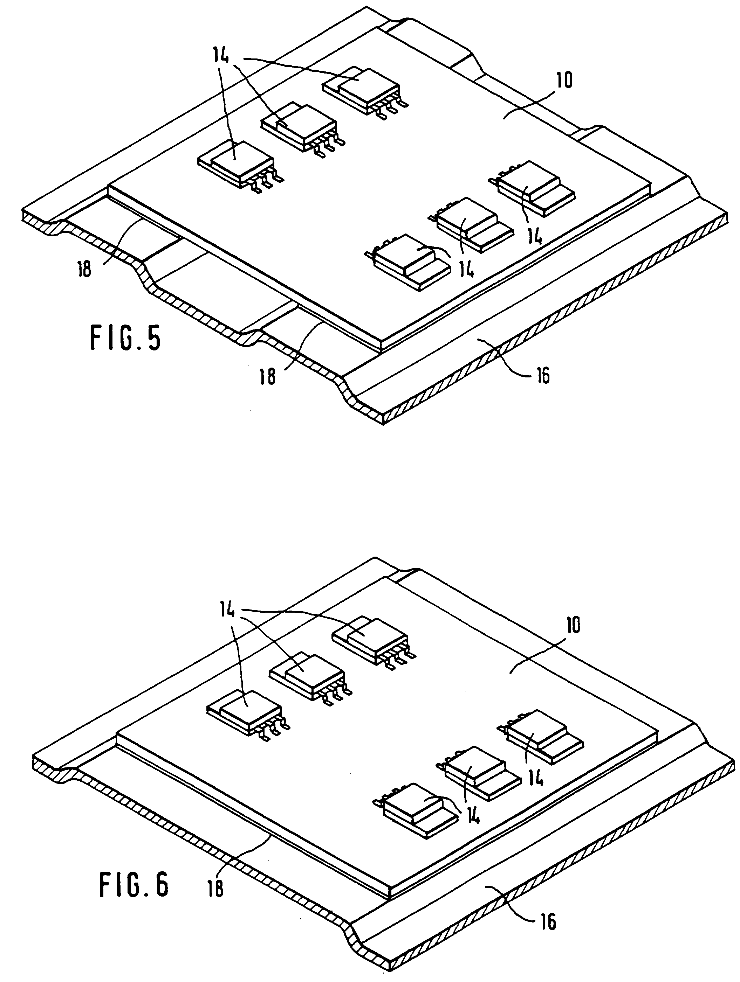

Figur 5 zeigt eine Leiterplatte 10 samt Kühlkörper 16 in perspektivischer Darstellung, wobei auf die Leiterplatte 10 entlang zweier einander gegenüberliegender Seitenkanten je eine Reihe von drei SMD-Leistungsbauelementen 14 angebracht ist. Weiterhin ist in Figur 5 für alle sechs SMD-Leistungsbauelemente 14 ein gemeinsamer Kühlkörper 16 vorgesehen. Unterhalb jeder der beiden Reihen von Leistungsbauelementen 14 steht der Kühlkörper 16 über je eine Kupferschicht 18 ohne Zwischenschaltung einer Glasgewebeschicht direkt mit der Leiterplatte 10 in Verbindung, so daß die sechs SMD-Leistungsbauelemente potentialmäßig miteinander gekoppelt sind. Im Bereich zwischen den beiden Reihen von Leistungsbauelementen 14 verläuft der Kühlkörper 16 in einem Abstand zur Leiterplatte 10 derart, daß auch an der Unterseite der Leiterplatte Bauelemente montierbar sind.

Wenn an der Unterseite der Leiterplatte 10 keine elektrischen Bauteile 19 angebracht werden sollen, ist vorgesehen, die Kupferschicht 18 und den Kühlkörper 16 ganzflächig an der Leiterplatte 10 anzubringen, wie in Figur 6 dargestellt.

Wenn die SMD-Leistungsbauelemente 14 potentialmäßig voneinander getrennt werden sollen, ist es bei den Ausführungsbeispielen nach den Figuren 5 und 6 auch möglich, wie bei den Ausführungsbeispielen nach den Figuren 1 und 2 zwischen der Leiterplatte 10 und der Kupferschicht 18 eine Glasgewebeschicht 17 anzubringen.

## Patentansprüche

1. Anordnung mit einer Leiterplatte (10), mindestens einem Leistungsbauelement (14) wobei das Leistungsbauelement (14) an einer ersten Hauptoberfläche der Leiterplatte (10) auf einer ersten großflächigen Leiterbahn (120), die von den übrigen, an dieser Hauptoberfläche befindlichen Leiterbahnen elektrisch isoliert ist, oberflächenmontiert ist, wobei auf der dem Leistungsbauelement (14) gegernüberliegenden zweiten Hauptoberfläche der Leiterplatte (10) sich eine zweite großflächige Leiterbahn (130) befindet, und die an der ersten Hauptoberfläche der Leiterplatte (10) angebrachte erste großflächige Leiterbahn (120) mit der an der zweiten Hauptoberfläche der Leiterplatte (10) angebrachten zweiten großflächigen Leiterbahn (130) über mindestens eine Durchkontaktierung (100), vorzugsweise über eine Vielzahl von Durchkontaktierungen (100), gut wärmeleitend verbunden ist dadurch gekennzeichnet, daß sich zwischen der an der zweiten Hauptoberfläche der Leiterplatte (10) angebrachten zweiten großflächigen Leiterbahn (130) und einem Kühlkörper (16) eine vorzugsweise aus Kupfer bestehende Metallschicht (18) angeordnet ist, und daß zur potentialmäßigen Trennung des mindestens einen Leistungsbauelements (14) von dem Kühlkörper (16) zwischen der an der zweiten Hauptoberfläche der Leiterplatte (10) angebrachten zweiten großflächigen Leiterbahn (130) und der Metallschicht (18) eine Glasgewebeschicht (17) angeordnet ist.

2. Anordnung nach Anspruch 1, dadurch gekennzeichnet, daß zwischen dem Leistungsbauelement (14) und der an der ersten Hauptoberfläche der Leiterplatte (10) angebrachten ersten großflächigen Leiterbahn (120) ein Wärmeableitstück (15) vorgesehen ist.

## Claims

1. Arrangement with a printed circuit board (10) and at least one power component (14), the power component (14) being surface-mounted, on a first main surface of the printed circuit board (10), on a first large-area conductor track (120) which is electrically insulated from the remaining conductor tracks located on this main surface, a second large-area conductor track (130) being located on the second main surface, opposite to the power component (14), of the printed circuit board (10), and the first large-area conductor track (120) provided on the first main surface of the printed circuit board (10) being connected in a readily thermally conducting manner, via at least one plated-through hole (100), preferably via a multiplicity of plated-through holes (100), to the second large-area conductor track (130) provided on the second main surface of the printed circuit board (10), characterized in that a metal layer (18), which preferably consists of copper, is arranged between the second large-area conductor track (130) provided on the second main surface of the printed circuit board (10) and a heat sink (16), and in that a glass fabric layer (17) is arranged between the second large-area conductor track (130) provided on the second main surface of the printed circuit board (10) and the metal layer (18) for the purpose of potential isolation of the at least one power component (14) from the heat sink (16).

2. Arrangement according to Claim 1, characterized in that a heat-dissipating element (15) is provided between the power component (14) and the first large-area conductor track (12) provided on the first main surface of the printed circuit board (10).

## Revendications

1. Dispositif comportant une plaque de circuit imprimé (10), au moins un composant de puissance (14), monté sur une première face principale de la plaque de circuit imprimé (10), sur un premier chemin conducteur (120) de grande surface, isolé électriquement des autres chemins conducteurs occupant cette face supérieure principale, tandis qu'en regard de la seconde face supérieure principale de la plaque de circuit imprimé (10) opposée au composant de puissance (14), on trouve un second chemin conducteur de grande surface (130) et le premier chemin conducteur de grande surface (120) garnissant la première face supérieure principale de la plaque de circuit imprimé (10) est relié au second chemin conducteur de grande surface (130) prévu sur la seconde face supérieure principale de la plaque de circuit imprimé (10) par au moins un contact traversant (100), de préférence par un grand nombre de contacts traversants (100), pour assurer une bonne liaison thermique, caractérisé en ce qu'entre le second chemin conducteur de grande surface (130) prévu sur la seconde face principale de la plaque de circuit imprimé (10) et un radiateur (16) on a une couche métallique (10), de préférence en cuivre, et pour la séparation de potentiel d'au moins un composant de puissance (14) par rapport au radiateur (16), entre le second chemin conducteur de grande surface (130) prévu sur la seconde face principale de la plaque de circuit imprimé (10) et la couche métallique (18) on a une couche de tissu de verre (17).

2. Dispositif selon la revendication 1, caractérisé par une pièce d'évacuation de chaleur (15) prévue entre le composant de puissance (14) et le premier chemin conducteur de grande surface (120) prévu sur la première face principale de la plaque de circuit imprimé (10).
